(19) Europäisches Patentamt

European Patent Office

Office européen des brevets

(11) **EP 0 729 185 B1**

(12) **EUROPEAN PATENT SPECIFICATION**

(45) Date of publication and mention
of the grant of the patent:
**14.07.2004 Bulletin 2004/29**

(51) Int Cl.⁷: **H01L 27/02**, H02H 7/18,
H02J 7/10, H01L 29/78

(21) Application number: **96400389.1**

(22) Date of filing: **23.02.1996**

(54) **Improvements in or relating to charge monitoring devices**

Verbesserungen in oder in Beziehung zu Anordnungen für Ladungskontrollen

Améliorations de ou en relation avec des dispositifs de contrôle d'état de charge

(84) Designated Contracting States:
**DE FR GB IT NL**

(30) Priority: **23.02.1995 FR 9502141**
**12.04.1995 FR 9504409**

(43) Date of publication of application:
**28.08.1996 Bulletin 1996/35**

(72) Inventor: **Farley, Joseph D.**
**06270 Villeneuve Loubet (FR)**

(74) Representative: **Jacobson, Claude et al**
**Cabinet Lavoix**
**2, Place d'Estienne d'Orves**
**75441 Paris Cedex 09 (FR)**

(73) Proprietors:
• **TEXAS INSTRUMENTS FRANCE**
**06271 Villeneuve Loubet Cédex (FR)**
Designated Contracting States:
**FR**
• **TEXAS INSTRUMENTS INCORPORATED**
**Dallas, Texas 75265 (US)**
Designated Contracting States:
**DE GB IT NL**

(56) References cited:
**EP-A- 0 588 615**          **US-A- 4 709 202**
**US-A- 4 777 387**          **US-A- 5 105 251**
**US-A- 5 278 487**

• **PATENT ABSTRACTS OF JAPAN vol. 007, no.**
**186 (E-193), 16 August 1983 & JP-A-58 089866**
**(HITACHI SEISAKUSHO KK), 28 May 1983,**

## Description

The present invention relates to charge monitoring and protection devices for rechargeable battery elements.

It relates more particularly to an automatic charge monitoring device providing protection against overcharges, excessive discharges, excessive temperatures, short circuits and high currents at low resistance, particularly for rechargeable lithium elements.

Document EP 0 588 615 describes a device for protecting rechargeable elements comprising an element voltage detector, comparing means for comparing the voltage detected to a reference voltage to detect an overcharged or an overdischarged condition and a switching means for cutting off a charge or a discharged current when an overcharged or an overdischarged condition is detected. This switching means comprise two nMOS transistors, two parasitic diodes and a corresponding complex control circuitry. Mainly one of the transistors is used to control the charge of the element, while the other is used to control the discharge of the element.

However, these switching means are bulky and electrical energy is lost in the switching means and the control circuitry during operation.

The present invention aims to remedy to these mentioned problems.

It proposed therefore a protection device according to the first claim. It envisages, in particular : the protection of rechargeable lithium elements against damage due to overcharging, the protection or rechargeable lithium elements against damage caused by excessive discharges, charge balancing in the course of the full charging of a set of several lithium elements, charge balancing at the voltage corresponding to complete element discharge for sets of several lithium elements, the provision of switches in series, with low operation resistance, the provision of a semiconductor switch which can also be used as a current-measuring element, mechanical and electronic safety with respect to excessive currents and temperatures for cells and electronic circuits, safety against overvoltages for battery modules, monitoring of the battery current in the event of a breakdown of one or more elements, integration of the electronics on a single chip which requires only a low quiescent current, the production of a protection device in the form of a module of small size, of low weight and of low assembly cost price, integration of the electronic and mechanical assembly into a single compact unit, the use, for charging lithium battery modules, of chargers which are normally used for charging NiCd and NIMH elements.

The invention will be better understood on reading the description which will follow, given solely by way of example, and given by referring to the attached drawings, in which:

Fig. 1 is an electrical diagram of the protection device for elements in accordance with the invention;

Fig. 1a is a diagram representing the waveform of an element and the output signals from the corresponding comparator of the device of Figure 1;

Fig. 2 is a diagrammatic view in section of the structure of the novel nMOSFET field-effect transistor used in constructing the protection device of Figure 1;

Fig. 3 is an electrical diagram of a detailed plan of the logic used to select the balancing of the high or low charge levels;

Fig. 4 is a diagrammatic plan view of an example assembly of the protection device, with elements to be protected;

Fig. 5 is an electrical diagram of another embodiment of the protection device for elements according to the invention, with a charge state indicator;

Fig. 6 is a battery management flow chart with protection device according to the invention; and

Fig. 7 is a diagram of a cheap battery module with a charge state memory applicable to elements of different chemical natures, in which protection against overvoltages and undervoltages is not mandatory, this diagram also showing an example of an interface of a function of management by an application.

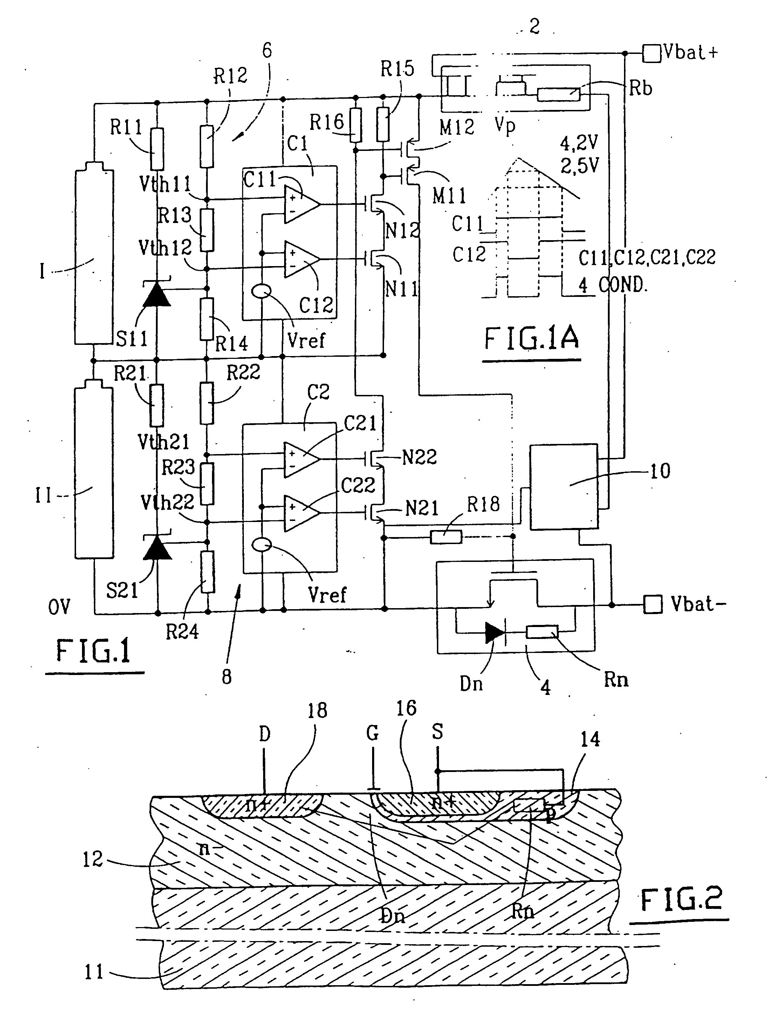

The protection device for rechargeable elements which are represented in Figure 1 consists of a mechanical protection unit 2 and of electronic circuit units 4, 6, 8 and 10. It is designed to provide protection for elements I, II, connected in series. The protection device and the elements together form a protected battery module with terminals Vbat+ and Vbat- to which a charger or an application, or a charger-application combination can be connected.

With the aim of clarity, the hysteresis circuit, the filtering circuits and the circuits for reducing the quiescent current when the elements have a low voltage are not represented.

The mechanical protection unit is a bimetallic strip switch 2 connected between the Vbat+ terminal and the most positive electrode of the series of elements, namely that of element I.

The most negative electrode of the series of elements, that is to say that of element II, is connected via a MOSFET power switching transistor 4, of specific construction, to the negative terminal Vbat- of the battery module.

The bimetallic strip switch 2 is, for example, a protector from the Zmm miniature-bimetallic strip series manufactured by the company Texas Instruments Inc.

In place of a bimetallic strip 2, a positive temperature coefficient thermistor, made of polymer or ceramic, of special construction, may also be used.

The FET transistor 4 is in fact a power switching MOSFET transistor, which will be described by reference to Figure 2.

Each of the elements I and II has a corresponding electronic circuit 6, 8 associated with it. The components of the circuits 6 and 8 which will now be described are designated by the same references, assigned the indices 1 or 2 respectively.

Thus, a shunt regulator S11, in series with a resistor R11, is connected to the terminals of the element I.

The control electrode of the shunt regulator S11 is connected to the junction point of two resistors R13, R14 which are connected in series with a resistor R12, forming a resistor chain also connected in parallel with the terminals of the element I.

The circuit 6 associated with the element I further includes a comparator assembly C1 itself also connected in parallel with the terminals of the element I. It includes two voltage comparators C11, C12 each having two inputs and a temperature-stable reference voltage source Vref.

The positive input of the comparator C11 is connected to the junction of the resistors R12, R13 and the negative input of the comparator C12 is connected to the junction of the resistors R13 and R14.

The negative input of the, comparator C11 and the positive input of the comparator C12 are both connected to the reference voltage source Vref. The output of the comparator C11 is connected to the gate of a FET transistor N12, while the output of the comparator C12 is connected to the gate of a FET transistor N11.

The sources and the drains of the FET transistors N12 and N11 are connected in series with a resistor R15 which is connected to the positive terminal of the element I.

The circuit 8 associated with the element II includes the same components as those of circuit 6 which are assigned the index 2.

The source-drain paths of the transistors N22, N21 which are associated with the comparators C21, C22 of circuit 8 are connected in series with a resistor R16, and this chain is linked in parallel with the set of two elements I and II.

The resistor R15 in series with the transistors N12 and N11 is connected to the gate of an FET transistor M11, while the resistor R16 which is linked in series with the transistors N22 and N21 is connected to the gate of a FET transistor M12.

The source-drain paths of the transistors M11, M12 are connected in series between the positive terminal of the element I and the gate electrode of the power MOSFET transistor 4.

The source-drain path of the MOSFET transistor 4 is connected between the negative terminal of the element II and the Vbat- terminal of the battery module.

A resistor R18 is connected between the source and the gate of the MOSFET transistor 4 and keeps it normally turned off. The shunt voltage regulators S11 and S21 use the resistors R11, R21 in series in order to limit the heating of these regulators while not affecting their regulation function, these resistors also providing current limiting during the low-voltage charge balancing and during certain operations with abnormal settings of element voltages.

The comparator units C1, C2 together with the resistors R15, R16 and the transistors N11, N12, N21, N22 produce an element voltage window within which the MOSFET power transistor 4 is kept turned on; the waveforms are illustrated in Figure 1A.

The comparator units C1, C2, together with the resistors R12, R13, R14, R22, R23, R24 and the shunt regulators S11, S21 regulate the maximum and minimum voltages at which shunting of the element currents occurs.

The MOSFET transistor 4 is represented in Figure 1 by a drain-source region, a gate electrode and a diode Dn in series with a resistor Rn, and this series impedance is represented as being connected between the drain and the source of the MOSFET transistor 4.

Between the bimetallic strip 2 and MOSFET transistor 4, an electronic protection circuit 10 is connected, which also forms part of the integrated circuit of the protection device.

A resistor Rb is present within the bimetallic unit in such a way that there is good thermal contact with it.

The protection circuit 10 switches a current through the resistor Rb on detection of a defect in operation of the power devices or of an excessive temperature of the whole of the integrated circuit.

The effect of the current passing through the resistor Rb is to heat the bimetallic strip, causing it to open. It may be designed to remain open after the passage of a hold current through the positive-temperature-coefficient resistor of the bimetallic strip, the latter closing only when the charging current is cut off.

The Zmm protection devices from Texas Instruments Inc. operate in this way.

In place of the resistor Rb, it is equally possible to use a positive-temperature-coefficient thermistor made of polymer or of ceramic which can cause the bimetallic strip to open or activate the PTC thermistor.

The MOSFET transistor 4, the structure of which is represented in Figure 2, comprises a substrate 11 on which an n- doped epitaxial layer 12 is obtained by growth.

Into the epitaxial layer 12 a p region 14 is diffused for the gate, into which an n+ source region 16 is also diffused. The same n+ dopant is simultaneously diffused into the epitaxial layer itself in order to form the drain electrode 18.

The resistance Rn of the transistor 4 is defined either by the p dopant of the gate backing and an epitaxial n- dopant, or by forming an appropriate connection between the source 16 and gate backing 14 so as to define a resistance essentially defined by the p dopant of the gate backing, or by choosing an appropriate resistor connected between the source and the gate backing which would be outside the p region. In all cases, it is appropriate, in the construction of the MOSFET transistor 4, to take care to avoid any turning-off of the device caused by transient voltages when the transistor 4 is turned on and turned off. A MOSFET transistor with a p type substrate 11 may be predisposed to such a phenomenon.

The n+ drain region 18 is diffused beside the gate region 14.

The diode Dn includes the gate p region 14 as its anode, and the n- region of the epitaxial layer 12 as its cathode.

The FET transistor 4 described is an nMOSFET and, by virtue of a careful configuration and by maximizing the width/length ratio (W/L) of the channel, a MOSFET transistor with very low conduction resistance can be produced. It is possible additionally to produce a heavily doped buried layer below the epitaxial layer 12.

If the doping of the buried layer is of n type, this layer increases the conductivity and limits the spurious vertical transistor action when the substrate is of p type.

The high W/L ratios with a minimum device dimension may additionally be obtained by using double-diffusion techniques with auto-alignment, which gives very small gate lengths.

The FET transistor 4 is held normally turned off by the resistor R18 connected between its source S and its gate G (Fig. 1). The outputs of the comparators C1 and C2 switch the FET transistor 4 so as to make it conduct the battery current whenever all the voltages of the elements are in their charge and discharge state in safety operating mode.

The FET transistor 4 is proposed as a novel type of FET transistor, especially designed for application to the battery protection device in module form.

The source S 16 is normally electrically connected to the gate backing in order to avoid modulation of Vt which would result from the overall effect of the gate backing.

The new switch holds the conduction voltage threshold at Vt, while using the diode Dn and the resistance Rn in order to define the reverse off-state impedance Zoffsd; the forward off-state impedance Zoffds remains like that of a FET transistor with normal turned-off state, that is to say close to an infinite ohmic value.

$$Zoffsd = Zdiode + Rn$$

$$Zoffds \to \infty$$

When the battery elements are in their normal operating voltage window, the FET transistor 4 is switched so as to operate in its triode region;

This shows that for low Vdrain-source (Vds) voltages in this region, the MOSFET has a resistance characteristic for a constant gate-source voltage.

In order to obtain the lowest conduction resistance Ron, the lowest voltage Vt is required for a given voltage Vgs.

It is proposed:

1) to use Vto by connecting the source 16 to the gate backing when the MOSFET 4 is conducting, which gives the minimum Vt voltage;
2) to put a gate backing contact in place so as to obtain a resistor Rn (of 10 to 500 ohms for the application of the protection device of the invention, or depending on the requirements of the system) in series with the diode Dn;
3) to use a constant voltage on the gate, so that a voltage drawn from a potential barrier allows the MOSFET, when it is turned on, also to be used as a current detection resistor in systems in which battery current measurements are required. The absolute value and the characteristic parameters of this resistor can be stored in a non-volatile memory of the battery module.

Another means for defining the resistor Rn consists in having a four-terminal MOSFET in which the gate backing is brought out as a separate terminal (while having a parallel resistor on the integrated circuit chip connected between the source 16 and the gate backing so as to keep the condition Vto and to avoid turning-off in the course of switching transitions).

This makes it possible to arrange a diode and a resistor in series, outside the MOSFET, which will define the reverse impedance of the device.

That being so, the MOSFET transistor 4 is, in the present example, a novel MOSFET power transistor of n polarity, having a very low conduction resistance and an off impedance approaching infinity in the normal off direction, and having a value determined by the diode Dn and the resistor Rn in the reverse off direction.

It is designed for the protection device according to the invention.

The value of the resistor Rn determined by the maximum voltage reached by the charger in the course of operation and by the level of the current chosen for charge balancing.

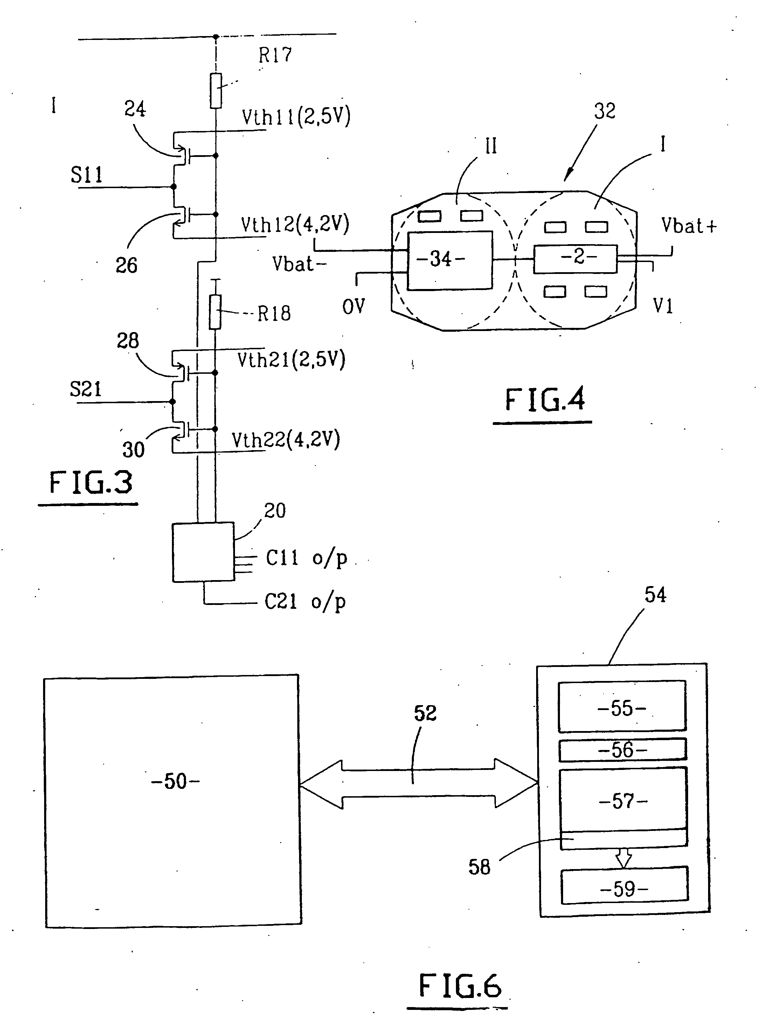

The logic circuit of Figure 3 is intended to select a low-voltage shunting or a high-voltage shunting as a function of the voltages of the elements.

The voltage balancing control logic circuit represented in Figure 3 includes a resistor R17 connected to a set of logic elements 20 including inputs connected respectively to the comparators C11 and C21.

Two FET transistors 24, 26 are used to connect the input electrode of the shunt regulator S11 to Vth11 or Vth12, which defines when shunting at minimum and maximum element voltages has to be carried out.

They are assigned to the element I and have their source-drain paths connected in series between the points Vth11 and Vth12 which define minimum and maximum safe operating thresholds for the element I.

The drains of the FET transistors 24, 26 are connected to the control electrode of the shunt regulator S11.

The gates of these transistors are both connected between the resistor R17 and the set of logic elements 20.

Two FET transistors 28, 30 are used to connect the input electrode of the shunt regulator S21 to Vth21 or Vth22 which define when shunting at minimum and maximum element voltages has to be carried out for the element II.

They are allocated to the element II and have their source-drain paths connected in series between the points Vth 21 and Vth 22 which define minimum and maximum safe operating thresholds for the element II.

The drains of the FET transistors 28, 30 are connected to the control electrode of the shunt regulator 21.

The gates of the FET transistors 28, 30 are connected between a resistor R18 linked to the positive terminal of the element I and the set of logic elements 20.

Figure 4 shows a circuit board on which the bimetallic strip element 2 and an integrated circuit 34 comprising the circuits 4, 6, 8 and the electronic protection circuit 10 described by reference to Figures 1 and 3 appear side by side. The cross-sections of the elements I and II are represented in broken lines. These elements are contained within the dimensions of the printed circuit board 32.

The electronic circuit of the protection device according to the invention is produced in the form of a single integrated circuit chip using linear MOS power technology, developed by the Applicant and designated by the title TI-PRISM, as well as Lin-Bi-CMOS technologies.

The circuit 34 and the bimetallic strip 2 may be placed in a single plastic casing.

The protection system represented in Figure 1 is intended for a battery module formed by two elements, but it may easily be extended to a greater number of elements given that the technology of the integrated circuits is capable of withstanding the maximum voltages required.

It will also be understood that such a protection system can be applied to a single rechargeable element.

The operation of the protection system will now be described by considering the various operating regions.

By way of example, lithium-ion elements having operating voltage limits of 2.5 volts and 4.2 volts are used to illustrate the operating principles of the system. The hystereses, the filtering of transients, the delay circuits and the quiescent-current reduction circuits are ignored for the sake of clarity of the explanations.

Region 1: Elements having undergone excessive discharge, $Vce11 \leq 2.5$ V

a) for less than 1.5 volts, the current of the elements is switched to 0 by the electronic circuit;

b) when the voltage of each element I, II is less than 2.5 volts, the shunt regulators S1, S2 are turned off. No discharge current can therefore flow through the MOSFET transistor 4 or through the diode Dn which is in the off-direction for discharge currents;

c) when the voltage on any one of the elements I and II is less than 2.5 volts, the shunt regulators of the remaining elements, the voltages of which are greater than 2.5 volts, are set so as to shunt them at 2.5 volts; this balances all the elements at 2.5 volts;

d) when a charger is connected to the Vbat+, Vbat- terminals of the battery module, the MOSFET transistor 4 remains turned off, but a current limited by the resistor Rn flows through the elements by means of the diode Dn and of the resistor Rn;

e) then, when all the elements have reached 2.5 V, the shunt regulators S11, S21 are reset to shunt the currents at 4.2 V;

Region 2: Elements being within their normal operating ranges, 4.2 V > V element > 2.5 V

a) when the voltages of all the elements are greater than 2.5 V, the shunt regulators are all set to shunt the current above 4.2 V per element;

b) when all the elements I, II are in this voltage region, the MOSFET transistor 4 is turned on and has a very low resistance in series for the charge and discharge currents;

c) for a battery module comprising a single element, or when the voltage available to switch the MOSFET transistor 4 is not sufficiently high for this transistor to reach the low conduction resistance Ron required, a charge pump can amplify the potential-barrier reference voltage up to the high gate-source voltage necessary for it to exhibit a very low conduction resistance. A constant gate-source voltage also gives the MOSFET transistor a resistance characteristic allowing it to be used as a current detection resistor.

Region 3: Overcharge voltage V element > 4.2V

a) the shunt voltage regulators S11 and S21 are respectively turned on when V element I or V element II reaches 4.2 V, and

b) the output of the comparators C11 or C12 no longer keeps the MOSFET transistor 4 turned on; it consequently resumes its normal off state. Any element situated above 4.2 V switches the MOSFET transistor so as to turn it off;

c) when the charger (not represented) is connected to the battery module, its current is consequently limited to the resistor Rn and the diode Dn, and this is so only when the elements have reached 4.2 V. Charge balancing takes place when the elements below 4.2 V continue to be charged with a reduced current; eventually all the elements will be charged to 4.2 V and all the shunt regulators will conduct the reduced charging current through the diode Dn and the resistor Rn back to the charger;

d) when the charger is withdrawn, the elements will be in their operating voltage region (2.5 V - 4.2 V) and the MOSFET transistor 4 will be kept turned on so that the charge and discharge currents flow in the low resistance triode region.

Region 4: Fault conditions

a) in the improbable event of the MOSFET transistor 4 being short-circuited because of a defect, and of a defect condition short-circuiting the terminals of the battery module, the bimetallic strip element 2 opens and remains in this state until the defect condition has been eliminated from the battery module;

b) if an abnormally high current flows through the elements and places the MOSFET transistor 4 outside its safe operating range or causes the integrated circuit to reach an abnormally high temperature, the electronic protection circuit applies a low voltage to the resistor Rb associated with the bimetallic strip element so that the current induced through it causes it to heat up sufficiently to open the bimetallic strip switch;

c) the protection circuit opens the bimetallic strip when it detects a battery module voltage Vbat+ - Vbat- greater than a predetermined value;

d) if all the electronic control means (MOSFET transistor 4, charger, electronic protection) suffer a breakdown in the course of rapid charging and if the elements I and II reach a high temperature, the bimetallic strip element operates as a backup mechanical safety protection device and stops the current flowing in the battery module;

e) if an element suffers a breakdown (element I or II) the broken-down element exhibits a voltage lower than 2.5 V and consequently switches the MOSFET transistor 4 so as to turn it off, thus interrupting the flow of high currents through the battery module. The other elements will thus be slowly discharged by the shunt regulators and, in this case, the resistors R12, R22 will limit the strength of the discharge currents.

The circuit represented in Figure 5 consists of a first part for forming the circuit of Figure 1, the components of which bear the same reference numbers and which will therefore not be described again, and a second part comprising a non-volatile memory such as an EEPROM 40, the positive power supply terminal of which is connected to a temperature sensor 42 which is in a heat exchanging relationship with the elements I and II.

The output of the memory 40 is connected to the terminals 44 of the battery module and also to a display module 46 comprising circuits with a high time constant for display, voltage and temperature measurement, and light-emitting diodes.

The power supply voltage for the EEPROM memory 40 and the temperature sensor can be taken from a common terminal Vcc.

The display module 46 is connected to the Vbat+ terminal via a charge-state display switch 48.

The non-volatile memory 40 makes it possible to store battery charge state parameters for the elements I, II at the instant corresponding to the charge state.

The display module contains certain electronic means for measuring the voltage and the temperature of the elements and for reading the charge state data contained in the memory 40. It determines the charge level of the elements to be displayed with low resolution, for example a 4-level LED assembly. Precise metering of the charge state is therefore not necessary for such display units on a module. When the display switch 48 is pushed in, a charge state based on a look-up table in the memory, with temperature-corrected voltage listings, will suffice for the display.

The flow chart represented in Figure 6 shows the protected battery module with a charge state indicator on the module, interfacing with an application 50 comprising a charge-measurement circuit. The charge management application circuit comprises a charge-measuring algorithm, components for taking precise measurements of charge state, a real-time clock and a data bus 52 between the application and the battery module 54. The battery module contains elements 55, the protection device 56 and a non-volatile memory, for example an EEPROM memory 57 which holds:

a real-time reference and
a temperature, a voltage, a corresponding current and
a corresponding charge state
charge, discharge coefficients and other charge determination parameters.

The EEPROM memory 57 is connected to a display interface circuit 58 which is connected to the charge state display device. The interface circuit and the display unit are used only if a charge state display option on the module is necessary.

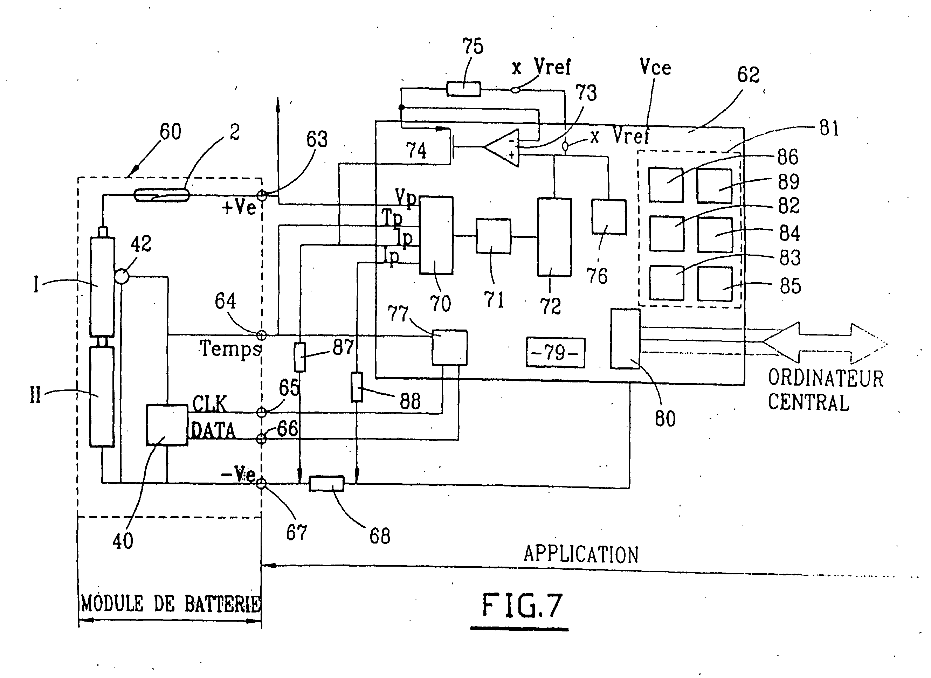

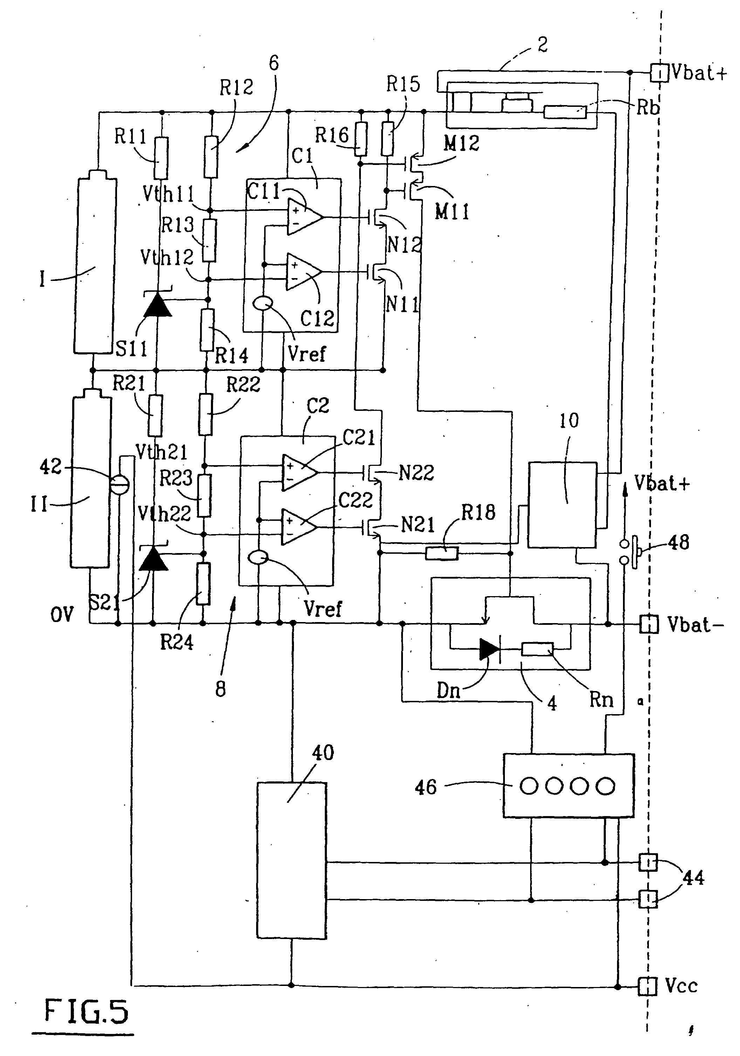

A system for charge measurement by the application is represented in Figure 7, and is applicable to a low-cost battery module 60 as well as to the battery module of Figure 5.

The low-cost battery module 60 comprises elements I and II, the EEPROM memory 40, to which is connected the temperature sensor 42 and the mechanical protection bimetallic strip switch 2. This battery module 60 can be used to hold the charge state data of a set of elements. These can be sets of NiCd, NiMH, etc. elements. The description which will follow applies both to the battery module system represented in Figure 5 and in Figure 7.

The EEPROM memory 40 is fed by the microprocessor 62 when the battery module is connected to the application. Consequently, it draws no current from the elements I and II even when it is not connected to the application. The charge state data, and other data, can be passed through the main processor (not represented) by the charge management microprocessor 62 through the data bus interface 80. The main processor can then be capable of carrying out the energy management functions for the application.

The protected battery module 60 is connected to the microprocessor 62 by five terminals 63 to 67.

Terminal 63 is the positive connection of the elements via the bimetallic strip 2, and is the positive energy terminal for the application of the charger.

Terminal 64 is the temperature detection terminal for the elements I and II and can be shared with the power supply for the non-volatile memory 40.

Terminals 65 and 66 are clock and data terminals forming an interface bus, for example 12C, between the non-volatile memory 40 and the application.

Terminal 67 is the terminal for connecting the negative terminal of the battery module and a current detection resistor 68 associated with the microprocessor 62 of the application.

The analogue inputs 70 of the microprocessor 62 are inputs for voltage Vp relating to the battery voltage Ve, for voltage relating to the temperature Tp of the element, and for current Ip of the elements.

These are multiplexed in the circuits 70 and 71 so as to be sent to a high-resolution analogue-digital converter 72.

A multiple of the potential barrier stabilized voltage reference 76 of the analogue-digital converter is connected to the non-inverting input of an operational amplifier 73, the output of which is connected to the gate of a FET transistor 74. The inverting output of the amplifier 73 is connected to the source of the FET transistor 74 and to a resistor 75. The other end of the resistor 75 is connected to a higher multiple of the potential barrier voltage.

The components 73, 74, 75 form a current source.

The FET transistor 74 delivers a constant current which is used to give a voltage shift determined by the product of the constant current and of a resistance value 87, and when it is connected to a resistor 88, the product of the constant current and of the value of the resistor 88. Due to the voltage shift obtained, the charge and discharge currents can be controlled from voltage measurements at the terminals of the current source and the detection resistor 68. The current source and the analogue-digital converter use the same potential barrier voltage reference giving a system ensuring accurate measurements.

The terminal 64 of the battery modules 60 may be to one of the universal input-output I/O terminals 77 of the charge measurement microprocessor 62. Equally, two other input-output I/O terminals 77 are connected to the terminals 65 and 66 of the non-volatile memory of the battery module for the operation of the clock and of the CLK and DATA information according to a protocol 12C for example.

The microprocessor 52 also has a local oscillator 79, a communication bus for communicating with the main computer, not represented, of the application, and other units necessary for its operation such as a ROM memory 82, a RAM memory 83, a central processing unit and timing means 85, as well as resetting means 86 and a real-time watchdog interrupt device 89.

By virtue of the microprocessor-type charge measuring configuration described above, management of the elements I and II of a battery can be controlled by the charge management processor of an application, and the charge state and other battery data can be sent to is the main computer for the purpose of displaying them and managing the energy of peripherals of the application.

The differences between the solution of a battery module and of its charge state monitoring according to the invention and of other solutions previously proposed in this field are as follows:

a) the use of a single power switch, such as the nMOSFET component 4. This exhibits a conduction resistance equal to half of that of existing solutions with two FETs;

b) the effects of losses of energy and of high temperatures for high-current applications such as portable computers, portable GSMs in which the currents coming from the battery module may reach 5 amps, are greatly reduced. At 100 mohms, (for example in present-day systems using a PTCR protection element with cold resistance of 50 m$\Omega$ and two power MOSFETs each of 25 m$\Omega$), 2.5 watts are dissipated; the protection system of the invention aims to reduce that by at least half. (For example, Rbimetallic strip + R MOSFET < 50 milliohms).

The MOSFET can be designed with a constant gate-source voltage when it is used as a detection resistor in systems requiring charge state indication. This further entails lower losses of energy from the battery and lower heat dissipation from the system;

c) no short-circuit protection fuse is necessary, as such a system is generally used with protection systems made from polymer or from ceramic with a positive temperature coefficient. This further lowers the energy losses as well as the number of components and the overall cost of the battery module;

d) the bimetallic strip exhibits the action of a reusable fuse;

e) a novel MOSFET which has a very low conduction resistance and an off resistance which is close to an infinite value in the forward direction and an off impedance defined in the reverse direction;

f) the shunt regulators S11, S22 are used to balance the charge at high and low voltage levels and to avoid overcharges;

g) the bimetallic strip 2 has a lower conduction resistance than protection devices with a positive temperature coefficient; the drift of the resistance over time is also improved;

h) the bimetallic strip element proposed has a resistor Rb through which a heating current can be applied so as to open the path of the main battery current;

i) electronic protection detects the safety parameters for operation of the integrated circuit (temperature, excessive currents and battery voltage); when such a situation is detected, it causes a current to pass through the resistor Rb in such a way as to interrupt the passage of battery current;

j) this protection system can evolve towards a single protection unit which comprises mechanical and electronic components.

As far as the charge state memory and the optional device for displaying the charge state, such as that represented in Figure 7, are concerned, it is also applicable to a low-cost battery module 60 with elements of any chemical nature;

k) the non-volatile memory is incorporated in the battery module and used to hold battery parameters, charge state data and corresponding time measurement, date, voltage, current and temperature data;

l) the light-emitting diode display module includes a corresponding electronic circuit for reading the data and the charge state table from the non-volatile memory, making temperature-corrected voltage readings with a view to display by means of an LED three-level or four-level unit when a request is made by pressing in the switch 48 of Figure 5. Accurate charge measurements are taken by the application each time the battery module is connected to the application, then written regularly into the non-volatile memory;

m) the power supply voltage and the non-volatile memory in the battery module can be shared with the temperature sensor. This avoids consumption of current from the elements and provides interfacing levels at correct voltage between the non-volatile memory and the charge measuring microprocessor 62 of the application. During the temperature measurements, the nonvolatile memory is placed in its power supply cut-off state. The current it consumes, for example of the order of a few microamperes, is sufficiently low as not to affect the accuracy of temperature measurement;

n) the battery module 60 becomes very cheap because of the low complexity of its circuits. The charge measurement functions are carried out by the application.

**Claims**

1. A device for protecting a rechargeable element (I) comprising :

   - a shunt regulator (S11, R11) for connection in parallel with said rechargeable element (I) ;
   - a network of resistors (R12, R13, R14) connected in parallel with said shunt regulator, the control electrode of said shunt regulator being connected to said network ;
   - comparator means (C1) connected in parallel with said network of resistors, the comparator means comprising a first comparator (C11), connected to one terminal of a resistor (R13) of said network, a second comparator (C12), connected to the other terminal of said resistor (R13), and a voltage reference source (Vref), to which are connected said first and second comparators (C11, C12), the network of resistors representing upper and lower threshold potentials (Vth11, Vth12) of said element and applying said potentials to the first and second comparators together with a reference potential from the voltage reference source (Vref) ;
   - bidirectional switching means (4) connected between a negative terminal of the element and a negative terminal (Vbat-) of said device, and operable under the control of said comparators to regulate the state of charge/discharge of the element, wherein :

   - said switching means have a low conduction resistance when the switching means are in a "on state", and a high off state impedance in a current direction and a defined off state impedance in an opposite current direction, when the switching means are in a "off state"; said defined off state impedance being less than said high off state impedance ;

- said defined impedance limits the charging current, when the switching means are off.

2. The device according to claim 1, wherein a plurality of said shunt regulators, each for connection in parallel with one of a plurality of rechargeable elements, are connected in series.

3. The device according to claim 1 or claim 2, wherein the switching means comprises a transistor.

4. The device according to claim 3, wherein the transistor is a field effect transistor (FET) comprising :

- an epitaxial layer (12) of a first conductivity type formed over a substrate (11);
- a region (14) of a second conductivity type formed in said epitaxial layer (12) ;
- a drain region (18) of said first conductivity type formed in said epitaxial layer (12) such that said region (14) and said drain region (18) are spaced ;
- a source region (16) of said first conductivity type formed in a first portion of said region (14) and positioned such that a gate backing region is formed substantially between said source region (16) and said epitaxial layer (12) ; and
- a diode (Dn) formed substantially in the region between said drain region (18) and said gate backing region.

5. The device according to claim 4, wherein the diode (Dn) defines an impedance between the source region (16) and the drain region (18) when the transistor is non-conducting.

6. The device according to claim 4 or claim 5, wherein the transistor is a MOSFET type transistor.

7. The device according to any of claims 4 to 6, wherein the transistor further comprises a resistor (Rn).

8. The device according to claim 7, wherein the resistor (Rn) is connected between the source region (16) and the gate backing region.

9. The device according to claim 7 or claim .8, wherein the resistor is formed in the gate backing region.

10. The device according to any one of claims 4 to 9, wherein in operation the transistor presents the low conduction resistance in its triode region.

11. The device according to any one of claims 7 to 10, wherein in operation the high impedance substantially prevents current flow in a first direction, and. wherein the impedance in a second direction opposite to the first direction is defined by the diode (Dn) and the resistor (Rn).

12. The device according to any one of claims 4 to 11, wherein the epitaxial layer (11) comprise a n-doped semiconductor material, the region (14) comprises a p type semiconducteur material, the source region (16) comprises an n+ doped semiconductor material, and the drain region (18) comprises an n+ doped semiconductor material.

13. The device according to claim 3 or claim 4, further comprising :

- a constant gate source voltage means coupled to the field effect transistor to prodúce a transistor impendance characteristic such that the transistor is capable of application in current-detecting measurements.

14. The device according to any one of claims 1 to 13, further comprising :

- a thermal protection means (2) connected between a positive terminal (Vbat+) of the device and a positive terminal of the element.

15. The device according to claim 14, wherein the thermal protection means comprises a bi-metallic strip.

16. The device according to claim 14, wherein the thermal protection means comprises a thermistor device having a positive temperature coefficient.

17. The device according to claim 16, wherein the thermistor device is formed from a polymer or a ceramic material.

18. The device according to any of claims 1 to 17 further comprising :

- selection logic circuity (20,22,24,26,28,30) for low-voltage and high-voltage charge balancing, and wherein output signals from the comparators are capable of controlling the control electrode of the shunt regulator.

19. The device according to any of claims 1 to 18, further comprising : electronic protection circuitry (10) connected to positive terminal (Vbat+) and the negative terminal (Vbat-) of the device.

20. The device according to any one of claims 1 to 19, further comprising :

- a non-volatile memory (40) for storing data corresponding to the state of charge, and/or of the charging characteristics of the element.

**21.** The device according to any one of claims 1 to 20, further comprising a temperature sensor supplied with voltage by a common source (Vcc) external to the device.

**22.** The device according to claim 21, wherein the temperature sensor is connected to the memory, the memory being arranged to store temperature data corresponding to the charging of the element.

**23.** The device according to claims 1 to 22, further comprising :

- means for displaying (46) the state of charge of the element.

**24.** The device according to claim 23, wherein the display means (46) is arranged to display data corresponding to data retrieved from the memory under the control of a charge state switch (48).

**25.** The device according to claims 1 to 24, further comprising :

- means for automatically controlling the operation of common charging apparatus.

**26.** The device according to claims 1 to 25, wherein said element is a Nickel-Cadmium (NiCd) or Nickel-Metal-Halide (NiMH) cell.

**27.** The device according to claims 1 to 26, further comprising :

- means for coupling an array of elements into the device, each element being electrically connected in series with adjacent elements.

**28.** A battery module (60) comprising :

- a device for protecting a rechargeable element (I) according to any of claims 1 to 27.

**Patentansprüche**

**1.** Vorrichtung zum Schützen eines wiederaufladbaren Elements (I) mit:

einem Nebenschlußregler (S11, R11) zur Parallelschaltung mit dem wiederaufladbaren Element (I),

einem Netzwerk von Widerständen (R12, R13, R14), die parallel zum Nebenschlußregler geschaltet sind, wobei die Steuerelektrode des Nebenschlußreglers mit dem Netzwerk verbunden ist,

einer Vergleichereinrichtung (C1), die parallel zum Widerstandsnetzwerk geschaltet ist, wobei die Vergleichereinrichtung einen ersten Vergleicher (C11), der mit einer Klemme eines Widerstands (R13) des Netzwerks verbunden ist, einen zweiten Vergleicher (C12), der mit der anderen Klemme des Widerstands (R13) verbunden ist, und eine Spannungsreferenzquelle (Vref), mit der der erste und der zweite Vergleicher (C11, C12) verbunden sind, aufweist, wobei das Widerstandsnetzwerk ein oberes und ein unteres Schwellenpotential (Vth11, Vth12) des Elements darstellt und die Potentiale zusammen mit einem Referenzpotential von der Spannungsreferenzquelle (Vref) an den ersten und den zweiten Vergleicher anlegt,

einer bidirektionalen Schalteinrichtung (4), die zwischen eine negative Klemme des Elements und eine negative Klemme (Vbat-) der Vorrichtung geschaltet ist und von den Vergleichern gesteuert einsetzbar ist, um den Lade/Entladezustand des Elements zu regeln, wobei:

die Schalteinrichtung einen niedrigen Leitungswiderstand aufweist, wenn sich die Schalteinrichtung in einem "Einschaltzustand" befindet, und eine hohe Ausschaltzustandsimpedanz in einer Stromrichtung und eine definierte Ausschaltzustandsimpedanz in einer entgegengesetzten Stromrichtung aufweist, wenn sich die Schalteinrichtung in einem "Ausschaltzustand" befindet, wobei die definierte Ausschaltzustandsimpedanz kleiner ist als die hohe Ausschaltzustandsimpedanz, und

die definierte Impedanz den Ladestrom begrenzt, wenn die Schalteinrichtung ausgeschaltet ist.

**2.** Vorrichtung nach Anspruch 1, wobei mehrere der Nebenschlußregler, die jeweils parallel zu einem der mehreren wiederaufladbaren Elemente zu schalten sind, in Reihe geschaltet sind.

**3.** Vorrichtung nach Anspruch 1 oder 2, wobei die Schalteinrichtung einen Transistor aufweist.

**4.** Vorrichtung nach Anspruch 3, wobei der Transistor ein Feldeffekttransistor (FET) ist, welcher aufweist:

eine Epitaxieschicht (12) eines ersten Leitfähigkeitstyps, die über einem Substrat (11) ausgebildet ist,

einen Bereich (14) eines zweiten Leitfähigkeitstyps, der in der Epitaxieschicht (12) ausgebildet ist,

einen Drain-Bereich (18) des ersten Leitfähigkeitstyps, der in der Epitaxieschicht (12) ausgebildet ist, so daß der Bereich (14) und der Drain-Bereich (18) beabstandet sind,

einen Source-Bereich (16) des ersten Leitfähigkeitstyps, der in einem ersten Abschnitt des Bereichs (14) ausgebildet ist und so positioniert ist, daß ein Gate-Unterlagsbereich im wesentlichen zwischen dem Source-Bereich (16) und der Epitaxieschicht (12) ausgebildet ist, und

eine Diode (Dn), die im wesentlichen in dem Bereich zwischen dem Drain-Bereich (18) und dem Gate-Unterlagsbereich ausgebildet ist.

5. Vorrichtung nach Anspruch 4, wobei die Diode (Dn) eine Impedanz zwischen dem Source-Bereich (16) und dem Drain-Bereich (18) definiert, wenn der Transistor nichtleitend ist.

6. Vorrichtung nach Anspruch 4 oder 5, wobei der Transistor ein MOSFET-Transistor ist.

7. Vorrichtung nach einem der Ansprüche 4 bis 6, wobei der Transistor weiter einen Widerstand (Rn) aufweist.

8. Vorrichtung nach Anspruch 7, wobei der Widerstand (Rn) zwischen den Source-Bereich (16) und den Gate-Unterlagsbereich geschaltet ist.

9. Vorrichtung nach Anspruch 7 oder 8, wobei der Widerstand in dem Gate-Unterlagsbereich ausgebildet ist.

10. Vorrichtung nach einem der Ansprüche 4 bis 9, wobei der Transistor beim Betrieb den niedrigen Leitungswiderstand in seinem Trioden-Bereich präsentiert.

11. Vorrichtung nach einem der Ansprüche 7 bis 10, wobei beim Betrieb die hohe Impedanz einen Stromfluß in einer ersten Richtung im wesentlichen verhindert und wobei die Impedanz in einer zweiten Richtung entgegengesetzt zur ersten Richtung durch die Diode (Dn) und den Widerstand (Rn) definiert ist.

12. Vorrichtung nach einem der Ansprüche 4 bis 11, wobei die Epiaxieschicht (11) ein n-dotiertes Halbleitermaterial aufweist, der Bereich (14) ein p-leitendes Halbleitermaterial aufweist, der Source-Bereich (16) ein (n+)-dotiertes Halbleitermaterial aufweist und der Drain-Bereich (18) ein (n+)-dotiertes Halbleitermaterial aufweist.

13. Vorrichtung nach Anspruch 3 oder 4, welche weiter aufweist:

eine konstante Gate-Source-Spannungs-Einrichtung, die mit dem Feldeffekttransistor gekoppelt ist, um eine solche Transistor-Impedanzkennlinie zu erzeugen, daß der Transistor bei Stromerfassungsmessungen anwendbar ist.

14. Vorrichtung nach einem der Ansprüche 1 bis 13, welche weiter aufweist:

eine thermische Schutzeinrichtung (2), die zwischen eine positive Klemme (Vbat+) der Vorrichtung und eine positive Klemme des Elements geschaltet ist.

15. Vorrichtung nach Anspruch 14, wobei die thermische Schutzeinrichtung einen Bimetallstreifen aufweist.

16. Vorrichtung nach Anspruch 14, wobei die thermische Schutzeinrichtung eine Thermistorvorrichtung mit einem positiven Temperaturkoeffizienten aufweist.

17. Vorrichtung nach Anspruch 16, wobei die Thermistorvorrichtung aus einem Polymer- oder einem Keramikmaterial besteht.

18. Vorrichtung nach einem der Ansprüche 1 bis 17, welche weiter aufweist:

eine Auswahllogik-Schaltungsanordnung (20, 22, 24, 26, 28, 30) für einen Niederspannungs- und Hochspannungs-Ladungsausgleich, wobei Ausgangssignale von den Vergleichern die Steuerelektrode des Nebenschlußreglers steuern können.

19. Vorrichtung nach einem der Ansprüche 1 bis 18, welche weiter aufweist:

eine elektronische Schutzschaltungsanordnung (10), die an die positive Klemme (Vbat+) und die negative Klemme (Vbat-) der Vorrichtung angeschlossen ist.

20. Vorrichtung nach einem der Ansprüche 1 bis 19, welche weiter aufweist:

einen nichtflüchtigen Speicher (40) zum Speichern von dem Ladezustand entsprechenden Daten und/oder der Ladekennlinien des Elements.

21. Vorrichtung nach einem der Ansprüche 1 bis 20, welche weiter einen Temperatursensor aufweist, dem eine Spannung von einer außerhalb der Vorrichtung liegenden gemeinsamen Quelle (Vcc) zugeführt wird.

22. Vorrichtung nach Anspruch 21, wobei der Temperatursensor mit dem Speicher verbunden ist, wobei der Speicher dafür eingerichtet ist, der Aufladung des Elements entsprechende Temperaturdaten zu speichern.

23. Vorrichtung nach den Ansprüchen 1 bis 22, welche weiter aufweist:

   eine Einrichtung (46) zum Anzeigen des Ladezustands des Elements.

24. Vorrichtung nach Anspruch 23, wobei die Anzeigeeinrichtung (46) dafür eingerichtet ist, Daten anzuzeigen, die Daten entsprechen, die von einem Ladezustandsschalter (48) gesteuert aus dem Speicher abgerufen werden.

25. Vorrichtung nach den Ansprüchen 1 bis 24, welche weiter aufweist:

   eine Einrichtung zum automatischen Steuern des Betriebs der gemeinsamen Ladevorrichtung.

26. Vorrichtung nach den Ansprüchen 1 bis 25, wobei das Element eine Nickel-Cadmium-(NiCd)- oder Nickel-Metallhalogenid-(NiMH)-Zelle ist.

27. Vorrichtung nach den Ansprüchen 1 bis 26, welche weiter aufweist:

   eine Einrichtung zum Koppeln einer Elementanordnung in die Vorrichtung, wobei jedes Element elektrisch in Reihe mit benachbarten Elementen geschaltet ist.

28. Batteriemodul (60) mit
   einer Vorrichtung zum Schützen eines wiederaufladbaren Elements (I) nach einem der Ansprüche 1 bis 27.

**Revendications**

1. Dispositif de protection d'un élément rechargeable (1) comprenant :

   un régulateur shunt (S11, R11) à connecter en parallèle audit élément rechargeable (I);
   un réseau de résistances (R12, R13, R14) connectées en parallèle audit régulateur shunt, l'électrode de commande dudit régulateur shunt étant connectée audit réseau ;
   des moyens de comparaison (C1) connectés en parallèle audit réseau de résistances, les moyens de comparaison comprenant un premier comparateur (C11), connecté à une borne d'une résistance (R13) dudit réseau, un second comparateur (C12), connecté à l'autre borne de ladite résistance (R13), et une source de référence de tension (Vref), à laquelle sont connectés lesdits premier et second comparateurs (C11, C12), le réseau de résistances représentant les potentiels de seuil supérieur et inférieur (Vth11, Vth12) dudit élément et appliquant lesdits potentiels aux premier et second comparateurs ensemble avec un potentiel de référence de la source de référence de tension (Vref) ;
   des moyens de commutation bidirectionnels (4) connectés entre une borne négative de l'élément et une borne négative (Vbat-) dudit dispositif, et utilisables sous le contrôle desdits comparateurs pour réguler l'état de charge/décharge de l'élément, dans lequel :

   lesdits moyens de commutation ont une résistance à faible conduction lorsque les moyens de commutation sont dans un « état actif », et une impédance d'état désactivé élevée dans une direction de courant et une impédance définie d'état désactivé dans une direction de courant opposée, lorsque les moyens de commutation sont dans un « état désactivé », ladite impédance définie d'état désactivé étant inférieure à ladite impédance d'état désactivé élevé ;
   ladite impédance définie limite le courant de charge, lorsque les moyens de commutation sont désactivés.

2. Dispositif selon la revendication 1, dans lequel une pluralité desdits régulateurs shunt, chacun pour la connexion en parallèle à un élément d'une pluralité d'éléments rechargeables, sont connectés en série.

3. Dispositif selon la revendication 1 ou la revendication 2, dans lequel les moyens de commutation comprennent un transistor.

4. Dispositif selon la revendication 3, dans lequel le transistor est un transistor à effet de champ (TEC) comprenant :

   une couche épitaxiale (12) d'un premier type de conductivité formé sur un substrat (11) ;
   une zone (14) d'un second type de conductivité formé dans ladite couche épitaxiale (12) ;
   une zone de drainage (18) dudit premier type de conductivité formé dans ladite couche épitaxiale (12) de telle sorte que ladite zone (14) et ladite zone de drainage (18) soient espacées ;

une zone source (16) dudit premier type de conductivité formé dans une première partie de ladite région (14) et positionnée de telle sorte qu'une zone de support de grille est sensiblement formée entre ladite zone source (16) et ladite couche épitaxiale (12) ; et

une diode (Dn) formée sensiblement dans une zone entre ladite zone de drainage (18) et ladite zone de support de grille.

5. Dispositif selon la revendication 4, dans lequel la diode (Dn) définit une impédance entre la zone source (16) et la zone de drainage (18) lorsque le transistor n'est pas conducteur.

6. Dispositif selon la revendication 4 ou la revendication 5, dans lequel le transistor est un transistor de type MOSFET.

7. Dispositif selon l'une quelconque des revendications 4 à 6, dans lequel le transistor comprend en outre une résistance (Rn).

8. Dispositif selon la revendication 7, dans lequel la résistance (Rn) est connectée entre la zone source (16) et la zone de support de grille.

9. Dispositif selon la revendication 7 ou la revendication 8, dans lequel la résistance est formée dans la zone de support de grille.

10. Dispositif selon l'une quelconque des revendications 4 à 9, dans lequel en fonctionnement le transistor présente la résistance à faible conduction dans sa zone triode.

11. Dispositif selon l'une quelconque des revendications 7 à 10, dans lequel en fonctionnement la haute impédance empêche sensiblement la circulation du courant dans une première direction et dans lequel l'impédance dans une seconde direction opposée à la première direction est définie par la diode (Dn) et la résistance (Rn).

12. Dispositif selon l'une quelconque des revendications 4 à 11, dans lequel la couche épitaxiale (11) comprend un matériau semi-conducteur dopé n, la zone (14) comprend un matériau semi-conducteur de type p, la zone source (16) comprend un matériau semi-conducteur dopé n+, et la zone de drainage (18) comprend un matériau semi-conducteur dopé n+.

13. Dispositif selon la revendication 3 ou la revendication 4, comprenant en outre :

des moyens de génération d'une tension de grille constante couplés au transistor à effet de champ pour produire des caractéristiques d'impédance de transistor de telle manière que le transistor peut être appliqué dans des mesures de détection du courant.

14. Dispositif selon l'une quelconque des revendications 1 à 13, comprenant en outre :

un moyen de protection thermique (2) connecté entre une borne positive (Vbat+) du dispositif et une borne positive de l'élément.

15. Dispositif selon la revendication 14, dans lequel le moyen de protection thermique comprend une bande bimétallique.

16. Dispositif selon la revendication 14, dans lequel le moyen de protection thermique comprend un dispositif de thermistor ayant un coefficient de température positif.

17. Dispositif selon la revendication 16, dans lequel le dispositif de thermistor est formé à partir d'un polymère ou d'un matériau en céramique.

18. Dispositif selon l'une quelconque des revendications 1 à 17, comprenant en outre :

un circuit logique de sélection (20, 22, 24, 26, 28, 30) pour l'équilibrage de charge haute tension et basse tension, et dans lequel les signaux de sortie à partir des comparateurs sont capables de contrôler l'électrode de commande du régulateur shunt.

19. Dispositif selon l'une quelconque des revendications 1 à 18, comprenant en outre :

un circuit de protection électronique (10) connecté à la borne positive (Vbat+) et à la borne négative (Vbat-) du dispositif.

20. Dispositif selon l'une quelconque des revendications 1 à 19, comprenant en outre :

une mémoire non-volatile (40) pour stocker les données correspondant à l'état de charge et/ou aux caractéristiques de charge de l'élément.

21. Dispositif selon l'une quelconque des revendications 1 à 20, comprenant en outre un capteur de température fourni avec la tension par une source commune (Vcc) externe au dispositif.

22. Dispositif selon la revendication 21, dans lequel le capteur de température est connecté à la mémoire, la mémoire étant agencée pour stocker les données relatives à la température correspondant à la charge de l'élément.

23. Dispositif selon les revendications 1 à 22, comprenant en outre :

un moyen d'affichage (46) de l'état de charge de l'élément.

24. Dispositif selon la revendication 23, dans lequel le moyen d'affichage (46) est agencé pour afficher les données d'affichage correspondant aux données extraites de la mémoire sous le contrôle d'un commutateur d'état de charge (48).

25. Dispositif selon les revendications 1 à 24, comprenant en outre :

des moyens pour contrôler automatiquement le fonctionnement de l'appareil de charge commun.

26. Dispositif selon les revendications 1 à 25, dans lequel ledit élément est une cellule en nickel-cadmium (NiCd) ou en nickel-métal halogénure (Ni-MH).

27. Dispositif selon les revendications 1 à 26, comprenant en outre :

des moyens pour coupler un ensemble d'éléments dans le dispositif, chaque élément étant électriquement connecté en série avec des éléments adjacents.

28. Support de piles (60) comprenant : ,

un dispositif pour protéger un élément rechargeable (I) selon l'une quelconque des revendications 1 à 27.

FIG.1

FIG.1A

FIG.2

FIG.3

FIG.4

FIG.6

ORDINATEUR CENTRAL

APPLICATION

MODULE DE BATTERIE

FIG.7

FIG.5